# EUROPEAN PATENT APPLICATION

(11) **EP 3 048 639 A1**
(43) Date of publication of application: **27.07.2016**
(21) Application number: 14850701.5
(22) Date of filing: 01.10.2014
(51) Int. Cl.: H01L 21/31, C23C 16/455, H01L 21/318

(54) **ATOMIC LAYER DEPOSITION DEVICE AND ATOMIC LAYER DEPOSITION METHOD**

(30) Priority: 03.10.2013 JP 2013208177
(71) Applicant: JSW AFTY Corporation, Tokyo 192-0918 (JP)
(72) Inventor: WASHIO Keisuke, Okayama 7068651 (JP)
(74) Representative: Prüfer & Partner mbB Patentanwälte · Rechtsanwälte
(86) International application number: PCT/JP2014/076322
(87) International publication number: WO 2015/050172

(57) **Abstract**

Provided is an atomic layer deposition apparatus that uniformly controls the film thickness throughout the entire area of a substrate.

Provided is an atomic layer deposition apparatus that forms a thin film on a substrate, the atomic layer deposition apparatus including: a film formation container in which the substrate is disposed inside, the film formation container provided with a plurality of exhaust ports for discharging an internal gas, the plurality of exhaust ports arranged at intervals and arranged parallel to a surface of the substrate on which the thin film is formed; a source gas supply unit that supplies a source gas of the thin film into the film formation container; a reactive gas supply unit that supplies, into the film formation container, a reactive gas for forming the thin film in reaction with a component of the source gas adsorbed to the substrate; exhaust valves connected to the exhaust ports; and a control unit that controls the plurality of exhaust valves to control an exhaust volume from each of the exhaust ports.

## Description

### Technical Field

The present invention relates to an atomic layer deposition apparatus and an atomic layer deposition method for forming a thin film on a substrate.

### Background Art

An atomic layer deposition method (ALD: Atomic Layer Deposition) is known as a technique for uniformly forming a thin film with excellent step coverage. In the ALD method, two types of gases (source gas and reactive gas) including main components that are elements constituting the thin film to be formed are alternately supplied onto a substrate, and the thin film consisting of atomic layers is formed on the substrate. A surface-reactive auto-stop function is used in the ALD method. The surface-reactive auto-stop function is a function in which only one layer or several layers of the source gas are adsorbed to the surface of the substrate during the supply of the source gas, and extra source gas does not contribute to the film formation. Therefore, the ALD method can be used to repeatedly form thin films consisting of atomic layers on the substrate to thereby form a thin film with a desired film thickness.

Compared to a general CVD (Chemical Vapor Deposition) method, the ALD method is excellent in step coverage and film thickness controllability. Therefore, the ALD method is used to form a capacitor of a memory device or to form an insulation film called a "high-k gate".

Furthermore, the insulation film can be formed at a temperature equal to or lower than 300°C in the ALD method. Therefore, the ALD method is used to form a gate insulation film of a thin film transistor in a display apparatus using a glass substrate, such as a liquid crystal display.

In the ALD method, a valve for supplying the source gas is opened in a pulsed manner, and the source gas is discharged into a film formation container in a reduced pressure atmosphere. When a liquid source is used, a vaporizer gasifies the liquid source. The source gas is used to form the thin film.

There is a liquid injection valve supply method for controlling the supply amount of the source to the film formation container in an atomic layer deposition apparatus in which the supply of gas is difficult or in an atomic layer deposition apparatus in which a large amount of sources need to be supplied. In the method, a liquid injection valve is opened for a certain time to supply a liquid source to the film formation container, and the liquid source is vaporized in an injector and becomes a source gas (Patent Literature 1).

### Citation List

### Patent Literature

Patent Literature 1: Japanese Patent Laid-Open No. 2012-167317

### Summary of Invention

### Technical Problem

In the conventional film formation container, exhaust ports for exhausting the source gas and the reactive gas are provided to extend parallel to a surface of the substrate on which the thin film is formed. The exhaust volume tends to be higher near a center section of the exhaust port and tends to be lower near both end sections. Therefore, the flow rate of the source gas is higher near the center section of the exhaust port, and the flow rate of the source gas is lower near the both end sections of the exhaust port. Therefore, the flow rate of the source gas cannot be uniform throughout the entire area of the substrate. The film thickness is thin in an area of the substrate close to the center section of the exhaust port, and it is difficult to make the film thickness uniform.

An object of the present invention is to uniformly control the film thickness throughout the entire area of a substrate.

### Solution to Problem

To solve the problem, a first aspect of the present invention provides an atomic layer deposition apparatus that forms a thin film on a substrate, the atomic layer deposition apparatus including:
a film formation container in which the substrate is disposed inside, the film formation container provided with a plurality of exhaust ports for discharging an internal gas, the plurality of exhaust ports arranged at intervals and arranged parallel to a surface of the substrate on which the thin film is formed;
a source gas supply unit that supplies a source gas of the thin film into the film formation container;
a reactive gas supply unit that supplies, into the film formation container, a reactive gas for forming the thin film in reaction with a component of the source gas adsorbed to the substrate;
exhaust valves connected to the exhaust ports; and
a control unit that controls the plurality of exhaust valves to control an exhaust volume from each of the exhaust ports.

Preferably, the atomic layer deposition apparatus further includes a film thickness measurement apparatus that measures a film thickness distribution of the thin film after film formation, wherein the control unit controls the exhaust volume from each of the exhaust valves according to a measurement result of the film thickness measurement apparatus.

Preferably, the atomic layer deposition apparatus further includes a film quality measurement apparatus that measures a film quality distribution of the thin film after the film formation, wherein the control unit controls the exhaust volume from each of the exhaust valves according to a measurement result of the film quality measurement apparatus.

Preferably, the film formation container is provided with a plurality of supply ports for supplying the source gas and the reactive gas into the film formation container, the plurality of supply ports arranged at intervals and arranged parallel to the surface of the substrate on which the thin film is formed,
the source gas supply unit includes a plurality of source gas valves for modulating a supply amount of the source gas supplied to each of the supply ports,
the reactive gas supply unit includes a plurality of reactive gas valves for modulating a supply amount of the reactive gas supplied to each of the supply ports, and
the control unit controls the plurality of source gas valves and reactive gas valves to control the supply amounts of the source gas and the reactive gas from the plurality of supply ports.

Preferably, further included is a film thickness measurement apparatus that measures a film thickness distribution of the thin film after the film formation, wherein
the control unit controls the supply amount of the source gas from each of the source gas valves and the supply amount of the reactive gas from each of the reactive gas valves according to a measurement result of the film thickness measurement apparatus.

Preferably, further included is a film thickness measurement apparatus that measures a film quality distribution of the thin film after the film formation, wherein
the control unit controls the supply amount of the source gas from each of the source gas valves and the supply amount of the reactive gas from each of the reactive gas valves according to a measurement result of the film quality measurement apparatus.

Preferably, further included is a purge gas supply unit that supplies, to each of the supply ports, a purge gas for discharging the source gas or the reactive gas from the film formation container, wherein
the purge gas supply unit includes a plurality of purge gas valves for modulating a supply amount of the purge gas supplied to each of the supply ports, and
the control unit controls the plurality of purge gas valves to control residence time of the source gas or the reactive gas in the film formation container.

Preferably, further included is a film thickness measurement apparatus that measures a film thickness distribution of the thin film after the film formation, wherein
the control unit controls the supply amount of the purge gas from each of the purge gas valves according to a measurement result of the film thickness measurement apparatus.

Preferably, further included is a film quality measurement apparatus that measures a film thickness distribution of the thin film after the film formation, wherein
the control unit controls the supply amount of the purge gas from each of the purge gas valves according to a measurement result of the film quality measurement apparatus.

A second aspect of the present invention provides an atomic layer deposition method of forming a thin film on a substrate, the atomic layer deposition method repeating the steps of:
supplying, to a film formation container, a source gas obtained by vaporizing a liquid source that is a source of the thin film and discharging the source gas from a plurality of exhaust ports provided on the film formation container and arranged at intervals parallel to a surface of the substrate on which the thin film is formed;
supplying, to the film formation container, a reactive gas for forming the thin film in reaction with a component of the source gas adsorbed to the substrate and discharging the reactive gas from the plurality of exhaust ports;
measuring, at a plurality of parts, a thickness of the thin film formed on the substrate; and
modulating exhaust volumes from the plurality of exhaust ports according to the measured thickness of the thin film.

A third aspect of the present invention provides an atomic layer deposition method of forming a thin film on a substrate, the atomic layer deposition method repeating the steps of:
supplying, to a film formation container, a source gas obtained by vaporizing a liquid source that is a source of the thin film and discharging the source gas from a plurality of exhaust ports provided on the film formation container and arranged at intervals parallel to a surface of the substrate on which the thin film is formed;
supplying, to the film formation container, a reactive gas for forming the thin film in reaction with a component of the source gas adsorbed to the substrate and discharging the reactive gas from the plurality of exhaust ports;
measuring, at a plurality of parts, a film quality of the thin film formed on the substrate; and
modulating exhaust volumes from the plurality of exhaust ports according to the measured film quality of the thin film.

A fourth aspect of the present invention provides an atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a reactive gas for forming the thin film in reaction with the source gas, from the plurality of supply ports to the film formation container;
measuring, at a plurality of parts, a thickness of the thin film formed on the substrate; and
modulating supply amounts of the source gas and the reactive gas from the plurality of supply ports according to the measured thickness of the thin film.

A fifth aspect of the present invention provides an atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a reactive gas for forming the thin film in reaction with the source gas, from the plurality of supply ports to the film formation container;
measuring, at a plurality of parts, a film quality of the thin film formed on the substrate; and
modulating supply amounts of the source gas and the reactive gas from the plurality of supply ports according to the measured film quality of the thin film.

A sixth aspect of the present invention provides an atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a purge gas for discharging the source gas from the film formation container, from the plurality of supply ports to the film formation container;
supplying a reactive gas for forming the thin film in reaction with the source gas, from the plurality of supply ports to the film formation container;
supplying a purge gas for discharging the reactive gas from the film formation container, from the plurality of supply ports to the film formation container;
measuring, at a plurality of parts, a thickness of the thin film formed on the substrate; and
modulating supply amounts of the purge gas from the plurality of supply ports according to the measured thickness of the thin film.

A seventh aspect of the present invention provides an atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a purge gas for discharging the source gas from the film formation container, from the plurality of supply ports to the film formation container;
supplying a reactive gas for forming the thin film in reaction with the source gas, from the plurality of supply ports to the film formation container;
supplying a purge gas for discharging the reactive gas from the film formation container, from the plurality of supply ports to the film formation container;
measuring, at a plurality of parts, a film quality of the thin film formed on the substrate; and
modulating supply amounts of the purge gas from the plurality of supply ports according to the measured film quality of the thin film.

### Advantageous Effects of Invention

According to the atomic layer deposition apparatus and the atomic layer deposition method of the present invention, the plurality of exhaust ports are dispersed in the horizontal direction and provided on the film formation container, and the flow rates of the source gas and the reactive gas exhausted from each exhaust port can be controlled to make the flow rates of the source gas and the reactive gas uniform throughout the entire area of the substrate. As a result, the film thickness can be uniformly controlled throughout the entire area of the substrate.

### Brief Description of Drawings

[Figure 1] Figure 1 is a schematic diagram showing an example of an atomic layer deposition apparatus of an embodiment.
[Figure 2] Figure 2 is a plan view showing an example of the atomic layer deposition apparatus.
[Figure 3] Figure 3 is a III arrow view of Figure 2.
[Figure 4] Figure 4 is a flow chart showing an example of an atomic layer deposition method of the embodiment.
[Figure 5] Figure 5 is a diagram showing processing of forming a thin film on a substrate.
[Figure 6] Figure 6 is a plan view showing an example of an atomic layer deposition apparatus.
[Figure 7] Figure 7 is a VII arrow view of Figure 6.

### Description of Embodiments

### <Embodiment>

### (Configuration of Atomic Layer Deposition Apparatus)

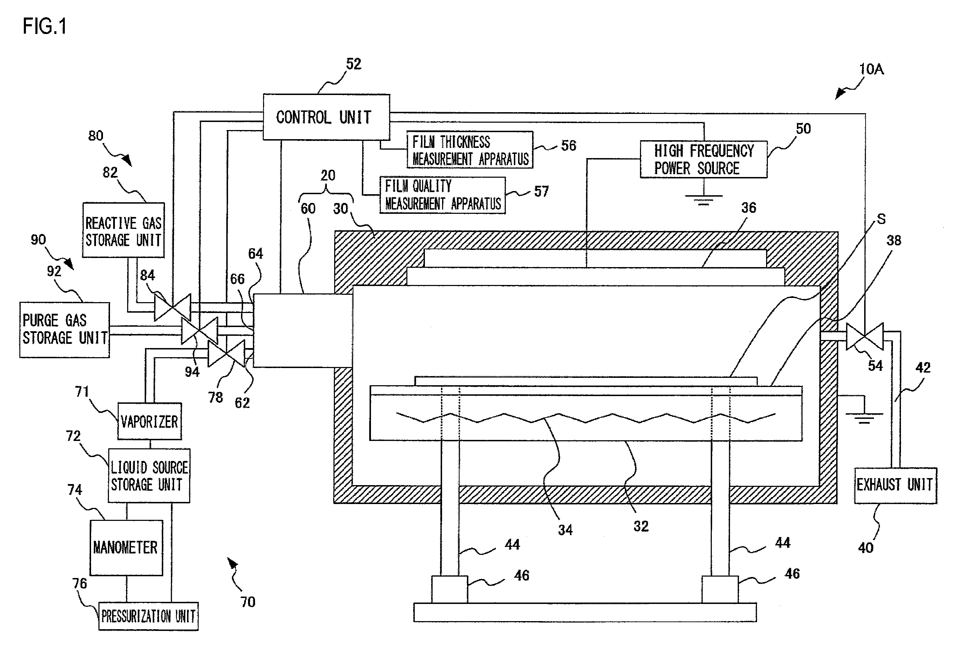

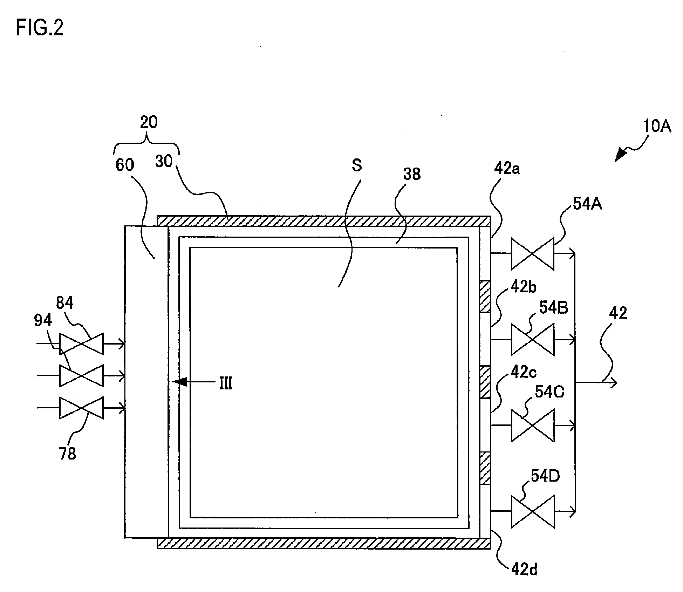

First, a configuration of an atomic layer deposition apparatus of the present embodiment will be described with reference to Figure 1. Figure 1 is a schematic block diagram showing an example of an atomic layer deposition apparatus 10A of the present embodiment, and Figure 2 is a plan view of the atomic layer deposition apparatus 10A. The atomic layer deposition apparatus 10A of the present embodiment alternately supplies a source gas and a reactive gas and forms a thin film consisting of atomic layers on a substrate S. In this case, plasma can also be generated to increase reaction activity. Although parallel plate electrodes are used to generate the plasma in the present embodiment, the system is not limited to this. Particularly, liquid sources are used at normal temperature and normal pressure to form the thin film in the present embodiment.

The atomic layer deposition apparatus 10A of the present embodiment includes a film formation container 20, an exhaust unit 40, a high frequency power source 50, a control unit 52, a source gas supply unit 70, a reactive gas supply unit 80, and a purge gas supply unit 90.

The film formation container 20 includes a vacuum chamber 30 and an injector 60.

First, the vacuum chamber 30 will be described. The vacuum chamber 30 includes a support unit 32, an upper electrode 36, and a lower electrode 38. The lower electrode 38 is provided on an upper surface of the support unit 32. Here, the lower electrode 38 is grounded. The substrate S is supported by lift pins 44 passing through the support unit 32 from below the vacuum chamber 30. Lifting mechanisms 46 can move the lift pins 44 up and down in a vertical direction, and in a state that the lift pins 44 support the substrate S, the lifting mechanisms 46 move the lift pins 44 downward to mount the substrate S on the lower electrode 38.

Furthermore, a heater 34 is provided inside of the support unit 32, and the heater 34 can adjust the temperature of the substrate S. For example, the substrate S is heated to 50 to 200°C in a case of plasma ALD.

The upper electrode 36 is provided above the substrate S and is connected to the high frequency power source 50. The high frequency power source 50 supplies a high frequency current with a predetermined frequency to generate plasma between the upper electrode 36 and the lower electrode 38.

Furthermore, the high frequency power source 50 is connected to the control unit 52. The control unit 52 controls the timing of the supply of the high frequency current to the upper electrode 36 by the high frequency power source 50.

A film thickness measurement apparatus 56 and a film quality measurement apparatus 57 are connected to the control unit 52.

The film thickness measurement apparatus 56 measures the thickness of the thin film formed on the substrate S and inputs the measurement information to the control unit 52. The film thickness can be measured with four points in an outer peripheral section and one point in a center section of the substrate based on, for example, reflectance spectroscopy (optical interferometry).

The film quality measurement apparatus 57 measures the film quality of the thin film formed on the substrate S and inputs the measurement information to the control unit 52. The film quality is measured by, for example, measuring the refractive index of the thin film with four points in the outer peripheral section and one point in the center section of the substrate. It can be evaluated that the thin film is dense if the refractive index is high, for example.

Note that in the present embodiment, the film thickness measurement apparatus 56 is provided outside of the vacuum chamber 30, and after the film formation, the thickness of the thin film on the substrate S taken out from the vacuum chamber 30 is measured. The film thickness measurement apparatus 56 can be provided inside of the vacuum chamber 30, and the thickness of the thin film formed on the substrate S in the vacuum chamber 30 can be measured.

The control unit 52 generates control signals and supplies the control signals to a source gas valve 78, a reactive gas valve 84, exhaust valves 54A, 54B, 54C, and 54D, and a purge gas valve 94.

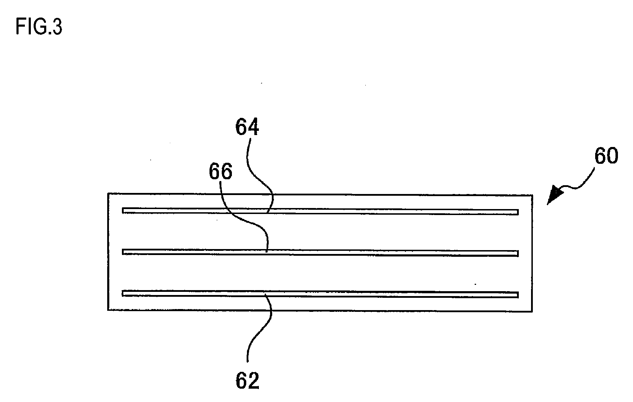

Next, the injector 60 will be described. The injector 60 supplies the source gas and the reactive gas into the vacuum chamber 30. Figure 3 is an elevation view of the injector 60 of Figure 2 as viewed in an arrow III direction. As shown in Figure 3, the injector 60 is provided with a source gas supply port 62 elongated in a horizontal direction (direction perpendicular to the paper surface of Figure 1), a reactive gas supply port 64 elongated in the horizontal direction, and a purge gas supply port 66 elongated in the horizontal direction. The source gas supplied from the source gas supply unit 70 is supplied into the film formation container 20 through the source gas supply port 62. The reactive gas supplied from the reactive gas supply unit 80 is supplied into the film formation container 20 through the reactive gas supply port 64. The reactive gas supplied from the purge gas supply unit 90 is supplied into the film formation container 20 through the purge gas supply port 66.

The exhaust unit 40 exhausts the source gas, the reactive gas, and the purge gas supplied into the film formation container 20 (vacuum chamber 30) through an exhaust pipe 42. The exhaust unit 40 is, for example, a dry pump.

The exhaust pipe 42 is connected to a plurality of exhaust ports 42a, 42b, 42c, and 42d provided on the vacuum chamber 30. The exhaust pipe 42 can be branched, or each of the exhaust ports 42a, 42b, 42c, and 42d can be provided with the exhaust pipe 42 and the exhaust unit 40.

The plurality of exhaust ports 42a, 42b, 42c, and 42d are arranged in a straight line at intervals in the horizontal direction, at an end section of the vacuum chamber 30 on the opposite side of the injector 60. The exhaust valves 54A, 54B, 54C, and 54D (see Figure 2) are provided at end sections of the exhaust pipe 42 closer to the exhaust ports 42a, 42b, 42c, and 42d, respectively. Note that the exhaust valves 54A, 54B, 54C, and 54D are indicated by one reference sign 54 in Figure 1.

The control unit 52 controls the opening and closing degrees of the exhaust valves 54A, 54B, 54C, and 54D and the timing of opening and closing. The exhaust valves 54A, 54B, 54C, and 54D open at predetermined opening degrees according to control signals of the control unit 52, and the exhaust unit 40 exhausts the gas in the vacuum chamber 30 through the exhaust pipe 42.

Because of that the exhaust unit 40 exhausts the vacuum chamber 30, even after the source gas, the reactive gas and the purge gas are supplied into the vacuum chamber 30, the degree of vacuum in the vacuum chamber 30 is maintained at about 10 Pa to 100 Pa.

Next, the source gas supply unit 70 will be described. The source gas supply unit 70 includes a vaporizer 71, a liquid source storage unit 72, a manometer 74, a pressurization unit 76, and the source gas valve 78.

The vaporizer 71 vaporizes a liquid source stored in the liquid source storage unit 72 and generates a source gas to be supplied to the injector 60.

The liquid source storage unit 72 stores the liquid source used to form the thin film. Examples of the liquid source stored in the liquid source storage unit 72 include TMA (trimethylaluminium), TDMAS (tris(dimethylamino)silane), TEMAZ (tetrakis(ethylmethylamino)zirconium), and TEMAH (tetrakis(ethylmethylamino)hafnium).

The manometer 74 detects the pressure of the liquid source storage unit 72. The data of the pressure detected by the manometer 74 is transmitted to the pressurization unit 76.

Based on the data of the pressure detected by the manometer 74, the pressurization unit 76 pressurizes the liquid source stored in the liquid source storage unit 72 such that the pressure of the liquid source becomes constant. The pressurization unit 76 pressurizes the liquid source by introducing an inert gas, such as N₂ gas and Ar gas, into the liquid source storage unit 72.

The source gas valve 78 modulates the flow rate of the source gas vaporized by the vaporizer 71 and supplies the source gas to the injector 60. An example of the source gas valve 78 that can be used includes an ALD valve of Swagelok Company.

Furthermore, the source gas valve 78 is connected to the control unit 52. The control unit 52 modulates the opening degree of the source gas valve 78 to control the flow rate of the source gas vaporized by the vaporizer 71.

Next, the reactive gas supply unit 80 will be described. The reactive gas supply unit 80 includes a reactive gas storage unit 82 and the reactive gas valve 84.

The reactive gas storage unit 82 stores the reactive gas used to form the thin film. Examples of the reactive gas stored in the reactive gas storage unit 82 include O₂ gas and N₂ gas.

The reactive gas valve 84 is connected to the control unit 52. The control unit 52 controls the opening degree of the reactive gas valve 84. The reactive gas valve 84 opens when the supply of the source gas into the film formation container 20 is stopped, and the reactive gas is supplied into the film formation container 20.

Next, the purge gas supply unit 90 will be described. The purge gas supply unit 90 includes a purge gas storage unit 92 and the purge gas valve 94.

The purge gas storage unit 92 stores a purge gas such as Ar gas. The purge gas valve 94 is connected to the control unit 52. The control unit 52 controls the opening degree of the purge gas valve 94.

Note that N₂ gas can be used as the purge gas. When the N₂ gas is used as the reactive gas, the reactive gas can be used in place of the purge gas, and the reactive gas supply unit 80 can be used in place of the purge gas supply unit 90.

The schematic configuration of the atomic layer deposition apparatus 10A of the present embodiment has been described.

Next, operation of the exhaust valves 54A, 54B, 54C, and 54D will be further described in detail with reference to Figure 2.

When the exhaust pipe 42 includes one exhaust port connected to the vacuum chamber 30, the flow rates of the source gas and the reactive gas are higher near a center section of the exhaust port, and the flow rates of the source gas and the reactive gas are lower at a section away from the center section of the exhaust pipe 42. Therefore, the flow rates of the source gas and the reactive gas cannot be uniform throughout the entire area of the substrate S. The film thickness is thin in an area away from the center section of the exhaust port of the substrate S, and it is difficult to make the film thickness uniform.

In the present embodiment, the plurality of exhaust ports 42a, 42b, 42c, and 42d are dispersed in the horizontal direction and provided on the vacuum chamber 30, and the exhaust pipe 42 is provided with the exhaust valves 54A, 54B, 54C, and 54D corresponding to the exhaust ports 42a, 42b, 42c, and 42d, respectively. Therefore, the opening degrees of the exhaust valves 54A, 54B, 54C, and 54D can be adjusted to control the flow rates of the source gas and the reactive gas exhausted from the exhaust ports 42a, 42b, 42c, and 42d. As a result, the flow rates of the source gas and the reactive gas can be uniform throughout the entire area of the substrate S.

For example, when the film thickness measured by the film thickness measurement apparatus 56 is thicker near the center section of the substrate S and thinner near the outer peripheral section, it is estimated that the flow rates of the source gas and the reactive gas are higher near the center section of the substrate S and lower near the outer peripheral section. In this case, among the exhaust ports 42a, 42b, 42c, and 42d arranged in a straight line at intervals in the horizontal direction, the opening degrees of the exhaust ports 42a and 42d at both end sections are increased, and the opening degrees of the exhaust ports 42b and 42c at the center sections are reduced. In this way, the flow rates of the source gas and the reactive gas in the outer peripheral section of the substrate S can be increased to about the same levels as the flow rates of the source gas and the reactive gas in the center section of the substrate S, and the flow rates of the source gas and the reactive gas can be uniform throughout the entire area of the substrate S.

When the film thickness measured by the film thickness measurement apparatus 56 is thinner near the center section of the substrate S and thicker near the outer peripheral section, the opening degrees of the exhaust ports 42a and 42d at both end sections are reduced, and the opening degrees of the exhaust ports 42b and 42c at the center section are increased. Therefore, the flow rates of the source gas and the reactive gas in the center section of the substrate S can be increased to about the same levels as the flow rates of the source gas and the reactive gas in the outer peripheral section of the substrate S, and the flow rates of the source gas and the reactive gas can be uniform throughout the entire area of the substrate S.

In this way, the opening degrees of the exhaust valves 54A, 54B, 54C, and 54D can be adjusted according to the distribution of the film thickness in the substrate S measured by the film thickness measurement apparatus 56, and a film with a uniform thickness can be formed on the substrate S.

When the film quality measured by the film quality measurement apparatus 57 is denser (higher refractive index) near the center section of the substrate S and sparser (lower refractive index) near the outer peripheral section, it is estimated that the flow rates of the source gas and the reactive gas are higher near the center section of the substrate S and lower near the outer peripheral section. In this case, among the exhaust ports 42a, 42b, 42c, and 42d, the opening degrees of the exhaust ports 42a and 42d at both end sections are increased, and the opening degrees of the exhaust ports 42b and 42c at the center section are reduced. In this way, the flow rates of the source gas and the reactive gas in the outer peripheral section of the substrate S can be increased to about the same levels as the flow rates of the source gas and the reactive gas in the center section of the substrate S, and the flow rates of the source gas and the reactive gas can be uniform throughout the entire area of the substrate S.

When the film quality measured by the film quality measurement apparatus 57 is sparser (lower refractive index) near the center section of the substrate S and denser (higher refractive index) near the outer peripheral section, the opening degrees of the exhaust ports 42a and 42d at both end sections are reduced, and the opening degrees, of the exhaust ports 42b and 42c at the center section are increased. Therefore, the flow rates of the source gas and the reactive gas in the center section of the substrate S can be increased to about the same levels as the flow rates of the source gas and the reactive gas in the outer peripheral section of the substrate S, and the flow rates of the source gas and the reactive gas can be uniform throughout the entire area of the substrate S.

In this way, the opening degrees of the exhaust valves 54A, 54B, 54C, and 54D can be adjusted according to the distribution of the film quality in the substrate S measured by the film quality measurement apparatus 57, and a thin film with a uniform film quality can be formed on the substrate S.

### (Atomic Layer Deposition Method)

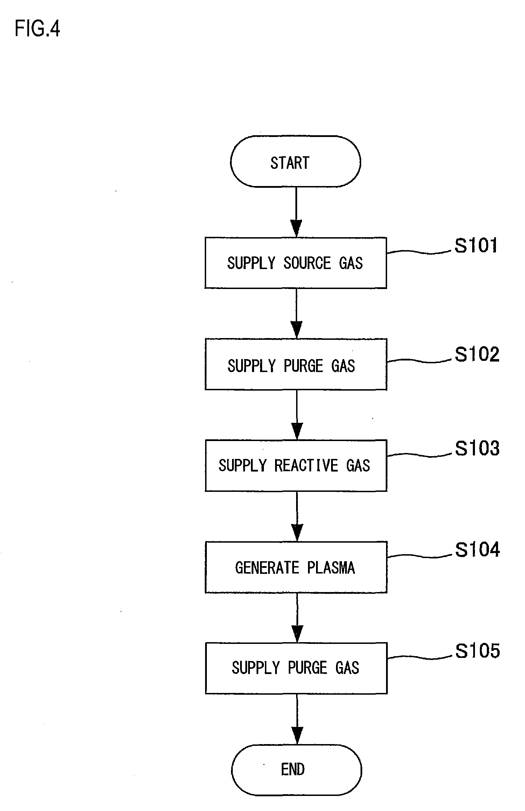

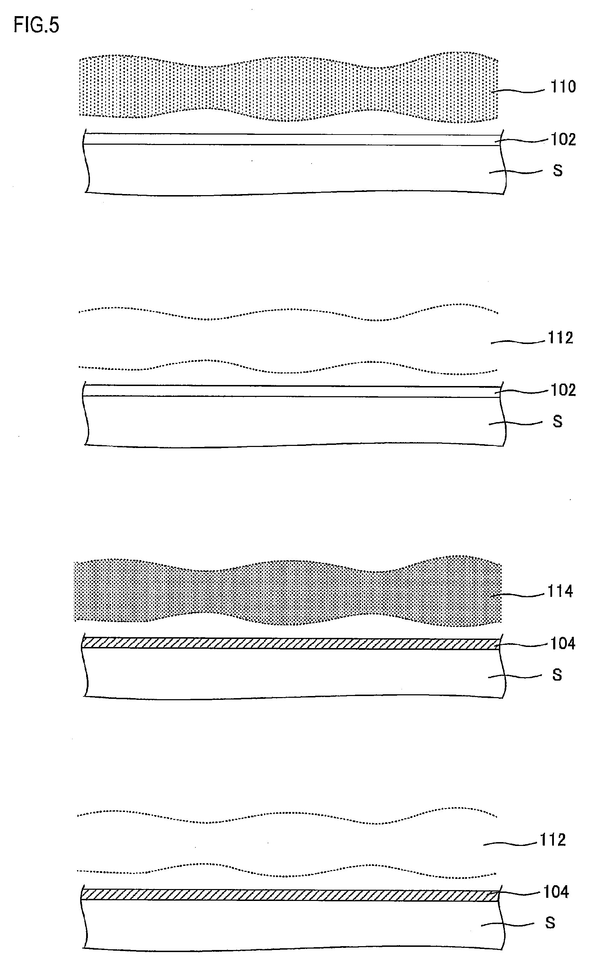

Next, an atomic layer deposition method using the atomic layer deposition apparatus 10A of the present embodiment will be described with reference to Figures 4 and 5. Figure 4 is a flow chart showing an example of one cycle of the atomic layer deposition method of the present embodiment. Figures 5(a) to (d) are diagrams showing processing of forming a thin film on the substrate S.

First, the source gas supply unit 70 supplies the source gas into the film formation container 20 (step S101).

In step S101, the manometer 74 detects the pressure of the liquid source storage unit 72, and based on the data of the pressure detected by the manometer 74, the pressurization unit 76 pressurizes the liquid source such that the pressure of the liquid source stored in the liquid source storage unit 72 becomes constant. Therefore, the liquid source storage unit 72 supplies the liquid source to the source gas valve 78 at a constant pressure.

The vaporizer 71 vaporizes the liquid source supplied from the liquid source storage unit 72, and at the timing controlled by the control unit 52, a source gas 110 is supplied into the film formation container 20 from the source gas supply port 62. In this case, the opening degrees of the exhaust valves 54A, 54B, 54C, and 54D are modulated to make the flow rate of the source gas 110 uniform throughout the entire area of the substrate S, and the exhaust unit 40 exhausts the gas inside of the film formation container 20.

As shown in Figure 5(a), the source gas 110 is supplied into the film formation container 20 as a result of step S101. The source gas 110 is adsorbed onto the substrate S, and an adsorbed layer 102 is formed.

Next, the purge gas supply unit 90 supplies the purge gas into the film formation container 20 (step S102). The control unit 52 sends a control signal for opening the purge gas valve 94, and the purge gas storage unit 92 supplies a purge gas 112 into the film formation container 20. For example, the purge gas valve 94 is opened for 0.1 seconds, and the purge gas 112 is supplied into the film formation container 20. Furthermore, the exhaust unit 40 exhausts the source gas 110 and the purge gas 112 inside of the film formation container 20. The exhaust unit 40 exhausts the source gas 110 and the purge gas 112 inside of the film formation container 20 for two seconds, for example. In this case, the opening degrees of the exhaust valves 54A, 54B, 54C, and 54D are modulated to make the flow rate of the source gas 110 uniform throughout the entire area of the substrate S, and the exhaust unit 40 exhausts the gas inside of the film formation container 20.

As shown in Figure 5(b), the purge gas 112 is supplied into the film formation container 20 as a result of step S102, and the source gas 110 not adsorbed onto the substrate S is purged from the film formation container 20. Note that the purge gas 112 can be supplied at the same time as the supply of the source gas 110.

Next, the reactive gas supply unit 80 supplies the reactive gas into the film formation container 20 (step S103). At the timing controlled by the control unit 52, the reactive gas valve 84 is opened, and a reactive gas 114 is supplied into the film formation container 20 from the reactive gas supply port 64. The reactive gas supply unit 80 supplies the reactive gas 114 into the film formation container 20 for one second, for example. In this case, the opening degrees of the exhaust valves 54A, 54B, 54C, and 54D are modulated to make the flow rate of the reactive gas 114 uniform throughout the entire area of the substrate S, and the exhaust unit 40 exhausts the gas inside of the film formation container 20.

As shown in Figure 5(c), the reactive gas 114 is supplied into the film formation container 20 as a result of step S103.

The high frequency power source 50 supplies a high frequency current with a predetermined frequency to the upper electrode 36 to generate plasma between the upper electrode 36 and the lower electrode 38 (step S104). The high frequency power source 50 generates the plasma of the reactive gas 114 for 0.2 seconds, for example. As a result of the generation of the plasma of the reactive gas 114 by the high frequency power source 50, the reactive gas 114 reacts with the adsorbed layer 102, and a thin layer 104 is formed.

Note that the timing of the generation of the plasma of the reactive gas 114 by the high frequency power source 50 can be the same as the timing of the supply of the reactive gas 114 into the film formation container 20 by the reactive gas supply unit 80.

Step S104 can be skipped when the reactive gas 114 reacts with the adsorbed layer 102 without the generation of the plasma. In this case, the heater 34 heats the substrate S to 200 to 400°C (thermal ALD) so that the reactive gas 114 sufficiently reacts with the adsorbed layer 102.

Next, the purge gas supply unit 90 supplies the purge gas 112 into the film formation container 20 (step S105). The purge gas supply unit 90 supplies the purge gas 112 into the film formation container 20 for 0.1 seconds, for example. Furthermore, the exhaust unit 40 exhausts the reactive gas 114 and the purge gas 112 inside of the film formation container 20. In this case, the opening degrees of the exhaust valves 54A, 54B, 54C, and 54D are modulated to make the flow rate of the reactive gas 114 uniform throughout the entire area of the substrate S, and the exhaust unit 40 exhausts the gas inside of the film formation container 20.

As shown in Figure 5(d), the purge gas 112 is supplied into the film formation container 20 in step S105, and the reactive gas 114 is purged from the film formation container 20.

As a result of steps S101 to S105 described above, the thin layer 104 equivalent to one atomic layer is formed on the substrate S. Steps S101 to S105 can be repeated to form the thin layer 104 with a desired film thickness.

Note that the film thickness measurement apparatus 56 can measure the film thickness every time steps S101 to S105 are repeated for a predetermined number of times, and the opening degrees of the exhaust valves 54A, 54B, 54C, and 54D can be modulated. In this way, a film with a uniform thickness throughout the entire area of the substrate S can be formed.

As described, the plurality of exhaust ports 42a, 42b, 42c, and 42d are dispersed in the horizontal direction and provided on the vacuum chamber 30 in the atomic layer deposition apparatus 10A of the present embodiment, and the exhaust pipe 42 is provided with the exhaust valves 54A, 54B, 54C, and 54D corresponding to the exhaust ports 42a, 42b, 42c, and 42d, respectively. Therefore, the opening degrees of the exhaust valves 54A, 54B, 54C, and 54D can be adjusted to control the flow rates of the source gas and the reactive gas exhausted from the exhaust ports 42a, 42b, 42c, and 42d. As a result, the flow rates of the source gas and the reactive gas can be uniform throughout the entire area of the substrate S.

Although the opening degrees of the exhaust valves 54A, 54B, 54C, and 54D are modulated to adjust the exhaust volumes from the exhaust ports 42a, 42b, 42c, and 42d in the case described in the embodiment, the present invention is not limited to this. The open time of the exhaust valves 54A, 54B, 54C, and 54D can be adjusted to adjust the exhaust volumes from the exhaust ports 42a, 42b, 42c, and 42d.

### <Modified Example>

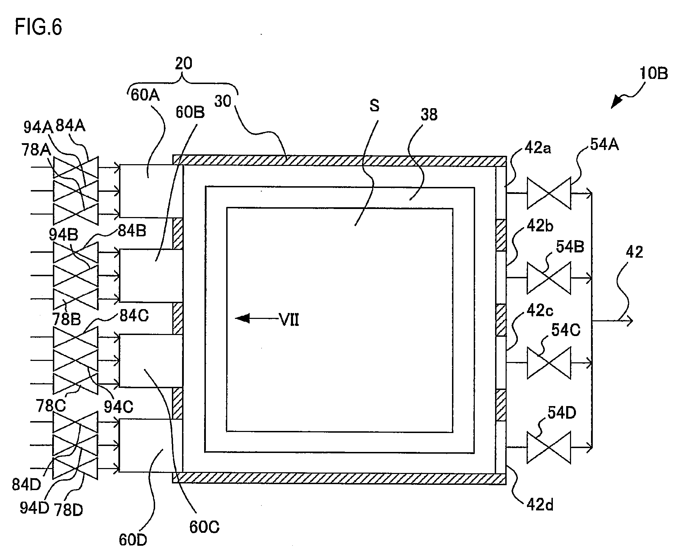

Figure 6 is a plan view similar to Figure 2, the plan view showing an atomic layer deposition apparatus 10B according to a modified example. Note that the same components as in the embodiment are designated with the same reference signs, and the description will not be repeated.

In the present modified example, a plurality of injectors 60A, 60B, 60C, and 60D for supplying the source gas, the reactive gas, and the purge gas to the vacuum chamber 30 are arranged in a straight line at intervals in the horizontal direction. Pipes for supplying the source gas, the reactive gas, or the purge gas are connected to each of the injectors 60A, 60B, 60C, and 60D. The pipes can be branched or can be provided on each of the injectors 60A, 60B, 60C, and 60D.

A source gas valve 78A, a reactive gas valve 84A, and a purge gas valve 94A are provided on the pipes for supplying the source gas, the reactive gas, and the purge gas to the injector 60A. A source gas valve 78B, a reactive gas valve 84B, and a purge gas valve 94B are provided on the pipes for supplying the source gas, the reactive gas, and the purge gas to the injector 60B. A source gas valve 78C, a reactive gas valve 84C, and a purge gas valve 94C are provided on the pipes for supplying the source gas, the reactive gas, and the purge gas to the injector 60C. A source gas valve 78D, a reactive gas valve 84D, and a purge gas valve 94D are provided on the pipes for supplying the source gas, the reactive gas, and the purge gas to the injector 60D.

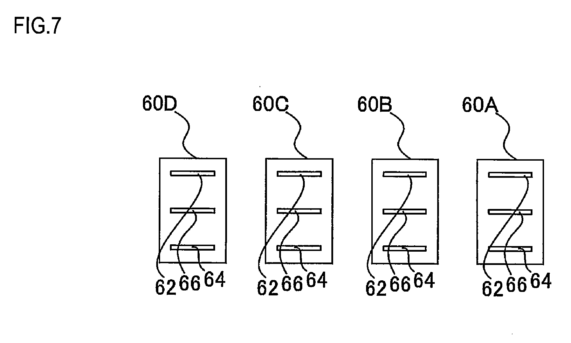

Figure 7 is an elevation view of the injectors 60A, 60B, 60C, and 60D of Figure 6 as viewed in an arrow VII direction. As shown in Figure 7, each of the injectors 60A, 60B, 60C, and 60D is provided with the source gas supply port 62 elongated in the horizontal direction (direction perpendicular to the paper surface of Figure 1), the reactive gas supply port 64 elongated in the horizontal direction, and the purge gas supply port 66 elongated in the horizontal direction as shown in Figure 3.

In the present modified example, the opening degrees of the source gas valves 78A, 78B, 78C, and 78D can be adjusted to control the flow rates of the source gas supplied from the source gas valves 78A, 78B, 78C, and 78D.

For example, when the film thickness measured by the film thickness measurement apparatus 56 is thicker near the center section of the substrate S and thinner near the outer peripheral section, or when the film quality measured by the film quality measurement apparatus 57 is denser (higher refractive index) near the center section of the substrate S and sparser (lower refractive index) near the outer peripheral section, it is estimated that the flow rates of the source gas and the reactive gas are higher near the center section of the substrate S and lower near the outer peripheral section.

In this case, among the source gas valves 78A, 78B, 78C, and 78D for supplying the source gas to the injectors 60A, 60B, 60C, and 60D arranged in a straight line at intervals in the horizontal direction, the opening degrees of the source gas valves 78A and 78D for supplying the source gas to the injectors 60A and 60D at both end sections are increased, and the opening degrees of the source gas valves 78B and 78C for supplying the source gas to the injectors 60B and 60C at the center section are reduced. In this way, the flow rates of the source gas in the outer peripheral section of the substrate S can be increased to about the same levels as the flow rates of the source gas in the center section of the substrate S, and the flow rates of the source gas can be uniform throughout the entire area of the substrate S.

Furthermore, the opening degrees of the reactive gas valves 84A, 84B, 84C, and 84D can be adjusted to control the flow rates of the reactive gas supplied from the reactive gas valves 84A, 84B, 84C, and 84D.

For example, among the reactive gas valves 84A, 84B, 84C, and 84D for supplying the reactive gas to the injectors 60A, 60B, 60C, and 60D arranged in a straight line at intervals in the horizontal direction, the opening degrees of the reactive gas valves 84A and 84D for supplying the reactive gas to the injectors 60A and 60D at both end sections are increased, and the opening degrees of the reactive gas valves 84B and 84C for supplying the reactive gas to the injectors 60B and 60C at the center section are reduced. In this way, the flow rates of the reactive gas in the outer peripheral section of the substrate S can be increased to about the same levels as the flow rates of the source gas in the center section of the substrate S, and the flow rates of the reactive gas can be uniform throughout the entire area of the substrate S.

In addition, the opening degrees of the purge gas valves 94A, 94B, 94C, and 94D can be adjusted to make the residence time of the source gas and the reactive gas uniform throughout the entire area of the substrate S.

For example, among the purge gas valves 94A, 94B, 94C, and 94D for supplying the purge gas to the injectors 60A, 60B, 60C, and 60D arranged in a straight line at intervals in the horizontal direction, the opening degrees of the purge gas valves 94B and 94C for supplying the purge gas to the injectors 60B and 60C at the center section are increased, and the opening degrees of the purge gas valves 94A and 94D for supplying the purge gas to the injectors 60A and 60D at both end sections are reduced. Therefore, the residence time of the source gas and the reactive gas in the outer peripheral section of the substrate S can be increased to about the same level as the residence time of the source gas and the reactive gas at the center section of the substrate S, and a film with a uniform thickness throughout the entire area of the substrate S can be formed.

In this way, the opening degrees of the source gas valves 78A, 78B, 78C, and 78D, the reactive gas valves 84A, 84B, 84C, and 84D, the purge gas valves 94A, 94B, 94C, and 94D, and the exhaust valves 54A, 54B, 54C, and 54D can be adjusted according to the distribution of the film thickness in the substrate S measured by the film thickness measurement apparatus 56, and a film with a uniform thickness can be formed on the substrate S.

Although the opening degrees of the source gas valves 78A, 78B, 78C, and 78D are modulated to adjust the supply amounts of the source gas from the injectors 60A, 60B, 60C, and 60D in the case described in the embodiment, the present invention is not limited to this. The open time of the source gas valves 78A, 78B, 78C, and 78D can be adjusted to adjust the supply amounts of the source gas from the injectors 60A, 60B, 60C, and 60D.

Furthermore, although the opening degrees of the reactive gas valves 84A, 84B, 84C, and 84D are modulated to adjust the supply amounts of the reactive gas from the injectors 60A, 60B, 60C, and 60D in the case described in the embodiment, the present invention is not limited to this. The open time of the reactive gas valves 84A, 84B, 84C, and 84D can be adjusted to adjust the supply amounts of the reactive gas from the injectors 60A, 60B, 60C, and 60D.

Furthermore, although the opening degrees of the purge gas valves 94A, 94B, 94C, and 94D are modulated to adjust the supply amounts of the purge gas from the injectors 60A, 60B, 60C, and 60D in the case described in the embodiment, the present invention is not limited to this. The open time of the purge gas valves 94A, 94B, 94C, and 94D can be adjusted to adjust the supply amounts of the purge gas from the injectors 60A, 60B, 60C, and 60D.

Although the number of supply ports of the source gas, the reactive gas, and the purge gas can be different from the number of exhaust ports, it is preferable that the number of supply ports and the number of exhaust ports are the same. This is because if the number of supply ports and the number of exhaust ports are the same, the supply amount and the exhaust volume can be synchronously adjusted.

Furthermore, it is preferable that the supply ports and the exhaust ports are provided to face each other across the substrate S as shown in Figure 6. This is because when the supply ports and the exhaust ports face each other, a source gas flow, a reactive gas flow, and a purge gas flow flowing over the substrate S from the supply ports to the exhaust ports become a laminar flow, and generation of a turbulent flow can be prevented.

### <Example>

A film formation apparatus including four injectors 60A, 60B, 60C, and 60D and four exhaust ports 42a, 42b, 42c, and 42d as shown in Figure 6 is used to form an AlON thin film on a G5 glass substrate of 1100mm x 1300mm. TMA (trimethylaluminium) is used as a liquid source (Al source), and oxygen and nitrogen are used as reactive gases.

The pulse length of the control signal is adjusted at the supply of the source gas to set the open time of the source gas valves 78A and 78D to 0.5 seconds and to set the open time of the source gas valves 78B and 78C to 0.1 seconds. Furthermore, the pulse length of the control signal is adjusted at the supply of the reactive gases to set the open time of all of the reactive gas valves 84A, 84B, 84C, and 84D to 1 second.

The opening degrees of all of the exhaust valves 54A, 54B, 54C, and 54D are set to 100% (fully open). The cycle as shown in Figure 4 is repeated 600 times to form an AlON thin film. The film thickness is measured with four points in the outer peripheral section and one point in the center section of the substrate based on reflectance spectroscopy, and the average film thickness is 100nm with variation of +4%.

### <Comparative Example>

A film formation apparatus including only one injector and one exhaust port is used to form an AlON thin film on a G5 glass substrate of 1100mm x 1300mm. TMA (trimethylaluminium) is used as a liquid source (Al source), and oxygen and nitrogen are used as reactive gases.

The pulse length of the control signal is adjusted at the supply of the source gas and the reactive gas to set the open time of the source gas valve to 0.3 seconds. The open time of the reactive gas valve is set to 1 second. The opening degree of the exhaust valve is set to 100% (fully open). The cycle as shown in Figure 4 is repeated 600 times to form an AlON thin film. The film thickness is measured with four points in the outer peripheral section and one point in the center section of the substrate based on reflectance spectroscopy, and the average film thickness is 100nm with variation of ±15%.

Although the atomic layer deposition apparatus and the atomic layer deposition method of the present invention have been described in detail, the present invention is not limited to the embodiment. It is obvious that various modifications and changes can be made without departing from the scope of the present invention.

For example, although four exhaust valves 54A, 54B, 54C, and 54D are used in the cases described in the embodiment and the modified example, the present invention is not limited to this, and the number of exhaust valves used can be an arbitrary number equal to or greater than two. For example, the number of exhaust valves used can be a power of two, such as 2, 8, 16, and 32 (2ⁿ exhaust valves, index n is a natural number).

Similarly, although four injectors 60A, 60B, 60C, and 60D are used in the case described in the modified example, the present invention is not limited to this, and the number of injectors used can be an arbitrary number equal to or greater than two. For example, the number of injectors used can be a power of two, such as 2, 8, 16, and 32 (2ⁿ injectors, index n is a natural number).

### Reference Signs List

10A, 10B atomic layer deposition apparatuses
20 film formation container
30 vacuum chamber
32 support unit
34 heater
36 upper electrode
38 lower electrode
40 exhaust unit
42 exhaust pipe
44 lift pin
46 lifting mechanism
50 high frequency power source
52 control unit
54, 54A, 54B, 54C, 54D exhaust valves
56 film thickness measurement apparatus
60 injector
62 source gas supply port
64 reactive gas supply port
66 purge gas supply port
70 source gas supply unit
71 vaporizer
72 liquid source storage unit
74 manometer
76 pressurization unit
78 source gas valve
80 reactive gas supply unit
82 reactive gas storage unit
84, 84A, 84B, 84C, 84D reactive gas valves
90 purge gas supply unit
92 purge gas storage unit
94, 94A, 94B, 94C, 94D purge gas valves
102 adsorbed layer
104 thin layer
110 source gas
112 purge gas
114 reactive gas
S substrate

## Claims

1. An atomic layer deposition apparatus that forms a thin film on a substrate, the atomic layer deposition apparatus comprising:
a film formation container in which the substrate is disposed inside, the film formation container provided with a plurality of exhaust ports for discharging an internal gas, the plurality of exhaust ports arranged at intervals and arranged parallel to a surface of the substrate on which the thin film is formed;
a source gas supply unit that supplies a source gas of the thin film into the film formation container;
a reactive gas supply unit that supplies, into the film formation container, a reactive gas for forming the thin film in reaction with a component of the source gas adsorbed to the substrate;
exhaust valves connected to the exhaust ports; and
a control unit that controls the plurality of exhaust valves to control an exhaust volume from each of the exhaust ports.

2. The atomic layer deposition apparatus according to claim 1, further comprising
a film thickness measurement apparatus that measures a film thickness distribution of the thin film after film formation, wherein
the control unit controls the exhaust volume from each of the exhaust valves according to a measurement result of the film thickness measurement apparatus.

3. The atomic layer deposition apparatus according to claim 1 or 2, further comprising
a film quality measurement apparatus that measures a film quality distribution of the thin film after the film formation, wherein
the control unit controls the exhaust volume from each of the exhaust valves according to a measurement result of the film quality measurement apparatus.

4. The atomic layer deposition apparatus according to any one of claims 1 to 3, wherein
the film formation container is provided with a plurality of supply ports for supplying the source gas and the reactive gas into the film formation container, the plurality of supply ports arranged at intervals and arranged parallel to the surface of the substrate on which the thin film is formed,
the source gas supply unit comprises a plurality of source gas valves for modulating a supply amount of the source gas supplied to each of the supply ports,
the reactive gas supply unit comprises a plurality of reactive gas valves for modulating a supply amount of the reactive gas supplied to each of the supply ports, and
the control unit controls the plurality of source gas valves and reactive gas valves to control the supply amounts of the source gas and the reactive gas from the plurality of supply ports.

5. The atomic layer deposition apparatus according to claim 4, further comprising
a film thickness measurement apparatus that measures a film thickness distribution of the thin film after the film formation, wherein
the control unit controls the supply amount of the source gas from each of the source gas valves and the supply amount of the reactive gas from each of the reactive gas valves according to a measurement result of the film thickness measurement apparatus.

6. The atomic layer deposition apparatus according to claim 4 or 5, further comprising
a film quality measurement apparatus that measures a film quality distribution of the thin film after the film formation, wherein
the control unit controls the supply amount of the source gas from each of the source gas valves and the supply amount of the reactive gas from each of the reactive gas valves according to a measurement result of the film quality measurement apparatus.

7. The atomic layer deposition apparatus according to any one of claims 4 to 6, further comprising
a purge gas supply unit that supplies, to each of the supply ports, a purge gas for discharging the source gas or the reactive gas from the film formation container, wherein
the purge gas supply unit comprises a plurality of purge gas valves for modulating a supply amount of the purge gas supplied to each of the supply ports, and
the control unit controls the plurality of purge gas valves to control residence time of the source gas or the reactive gas in the film formation container.

8. The atomic layer deposition apparatus according to claim 7, further comprising
a film thickness measurement apparatus that measures a film thickness distribution of the thin film after the film formation, wherein
the control unit controls the supply amount of the purge gas from each of the purge gas valves according to a measurement result of the film thickness measurement apparatus.

9. The atomic layer deposition apparatus according to claim 7 or 8, further comprising
a film quality measurement apparatus that measures a film quality distribution of the thin film after the film formation, wherein
the control unit controls the supply amount of the purge gas from each of the purge gas valves according to a measurement result of the film quality measurement apparatus.

10. An atomic layer deposition method of forming a thin film on a substrate, the atomic layer deposition method repeating the steps of:
supplying, to a film formation container, a source gas obtained by vaporizing a liquid source that is a source of the thin film and discharging the source gas from a plurality of exhaust ports provided on the film formation container and arranged at intervals parallel to a surface of the substrate on which the thin film is formed;
supplying, to the film formation container, a reactive gas for forming the thin film in reaction with a component of the source gas adsorbed to the substrate and discharging the reactive gas from the plurality of exhaust ports;
measuring, at a plurality of parts, a thickness of the thin film formed on the substrate; and
modulating exhaust volumes from the plurality of exhaust ports according to the measured thickness of the thin film.

11. An atomic layer deposition method of forming a thin film on a substrate, the atomic layer deposition method repeating the steps of:
supplying, to a film formation container, a source gas obtained by vaporizing a liquid source that is a source of the thin film and discharging the source gas from a plurality of exhaust ports provided on the film formation container and arranged at intervals parallel to a surface of the substrate on which the thin film is formed;
supplying, to the film formation container, a reactive gas for forming the thin film in reaction with a component of the source gas adsorbed to the substrate and discharging the reactive gas from the plurality of exhaust ports;
measuring, at a plurality of parts, a film quality of the thin film formed on the substrate; and
modulating exhaust volumes from the plurality of exhaust ports according to the measured film quality of the thin film.

12. An atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a reactive gas for forming the thin film in reaction with the source gas, from the plurality of supply ports to the film formation container;
measuring, at a plurality of parts, a thickness of the thin film formed on the substrate; and
modulating supply amounts of the source gas and the reactive gas from the plurality of supply ports according to the measured thickness of the thin film.

13. An atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a reactive gas for forming the thin film in reaction with the source gas, from the plurality of supply ports to the film formation container;
measuring, at a plurality of parts, a film quality of the thin film formed on the substrate; and
modulating supply amounts of the source gas and the reactive gas from the plurality of supply ports according to the measured film quality of the thin film.

14. An atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a purge gas for discharging the source gas from the film formation container, from the plurality of supply ports to the film formation container;
supplying a reactive gas for forming the thin film in reaction with the source gas, from the plurality of supply ports to the film formation container;
supplying a purge gas for discharging the reactive gas from the film formation container, from the plurality of supply ports to the film formation container;
measuring, at a plurality of parts, a thickness of the thin film formed on the substrate; and
modulating supply amounts of the purge gas from the plurality of supply ports according to the measured thickness of the thin film.

15. An atomic layer deposition method of forming a thin film on a substrate, the atomic layer deposition method repeating the steps of:
supplying a source gas obtained by vaporizing a liquid source that is a source of the thin film, from a plurality of supply ports provided at intervals and arranged parallel to a surface of the substrate on which the thin film is formed, to a film formation container;
supplying a purge gas for discharging the source gas from the film formation container, from the plurality of supply ports to the film formation container;
supplying a reactive gas for forming the thin film in reaction with the source gas, from the plurality of supply ports to the film formation container;
supplying a purge gas for discharging the reactive gas from the film formation container, from the plurality of supply ports to the film formation container;
measuring, at a plurality of parts, a film quality of the thin film formed on the substrate; and
modulating supply amounts of the purge gas from the plurality of supply ports according to the measured film quality of the thin film.
